# EUROPÄISCHE PATENTSCHRIFT

(11) **EP 0 889 685 B1**
(45) Veröffentlichungstag und Bekanntmachung des Hinweises auf die Patenterteilung: **14.08.2002**
(21) Anmeldenummer: 98106007.2
(22) Anmeldetag: 02.04.1998
(51) Int. Cl.: H05K 9/00

(54) **Abschirmgehäuse für Mikrowellenschaltungen**
Shielding enclosure for microwave circuits
Boîtier de blindage pour circuits à micro-ondes

(30) Priorität: 05.07.1997 DE 19728839
(43) Veröffentlichungstag der Anmeldung: 07.01.1999
(73) Patentinhaber: Marconi Communications GmbH, 71522 Backnang (DE)
(72) Erfinder: Kuschke, Wolfgang, 71570 Oppenweiler (DE); Gill, Hardial Singh, 71522 Backnang (DE); Konrath, Willibald, 71554 Weissach (DE)
(74) Vertreter: Heuer, Wilhelm, Dr.

(56) Entgegenhaltungen:
- EP-A- 0 609 942
- EP-A- 0 756 446
- US-A- 5 566 055

## Beschreibung

### Stand der Technik

Die vorliegende Erfindung betrifft ein Abschirmgehäuse für Mikrowellenschaltungen, in dem sich mehrere gegeneinander abgeschirmte Kammern befinden, in denen Schaltungseinheiten angeordnet sind, die gegenseitig elektromagnetisch entkoppelt sein sollen.

Üblicherweise wird ein mehrkammriges Gehäuse, in dem mehrere hochfrequenzdicht gegeneinander abgeschirmte Mikrowellenschaltungen untergebracht werden sollen, durch Herausfräsen der einzelnen Kammern aus einem massiven Metallkörper hergestellt. Ein so hergestelltes Abschirmgehäuse ist in der DE 35 04 726 C1 beschrieben. Die Herstellung eines solchen Gehäuses mit mehreren hochfrequenzdichten Kammern ist sehr aufwendig.

Aus der DE 43 19 965 A1 ist es bekannt, in Trennfugen des Gehäuses, z.B. zwischen Deckel und Gehäusewänden, ein Dichtprofil einzufügen, das aus einem elastischen Silikonpolymer mit eingelagerten Metallpartikeln besteht.

Aufgabe der vorliegenden Erfindung ist es, ein Abschirmgehäuse der eingangs genannten Art anzugeben, das mit einem möglichst geringen Aufwand herstellbar ist.

### Vorteile der Erfindung

Die genannte Aufgabe wird gemäß den Merkmalen des Anspruchs 1 dadurch gelöst, daß auf der Innenseite eines das Gehäuse verschließenden Deckels ein Substrat aus einem Polymer mit darin eingelagerten Metallpartikeln aufgebracht ist, wobei an dem Substrat Stege angeformt sind, welche bei aufgesetztem Deckel die Trennwände zwischen den Kammern bilden. Das Substrat mit seinen die Kammern bildenden Stegen kann auf die Innenseite des Deckels aufgegossen werden. Dabei kann eine beliebige Struktur des Substrats mit Stegen ohne großen Aufwand realisiert werden. Das Substrat aus einem Polymer mit darin eingelagerten Metallpartikeln erfüllt nicht nur eine Abschirmfunktion, sondern bedämpft auch gleichzeitig unerwünschte Resonanzfrequenzen in den Kammern.

Gemäß einem Unteranspruch besteht das Substrat vorzugsweise aus einer mit Eisenpulver gefüllten Silikonmasse.

### Zeichnung

Anhand eines in der Zeichnung dargestellten Ausführungsbeispiels wird nachfolgend die Erfindung näher erläutert. Es zeigen:
Figur 1 ein geöffnetes Abschirmgehäuse mit einer Sicht in das Innere des Gehäuses und
Figur 2 dasselbe Abschirmgehäuse mit einer Sicht auf die Innenseite seines Deckels.

### Beschreibung eines Ausführungsbeispiels

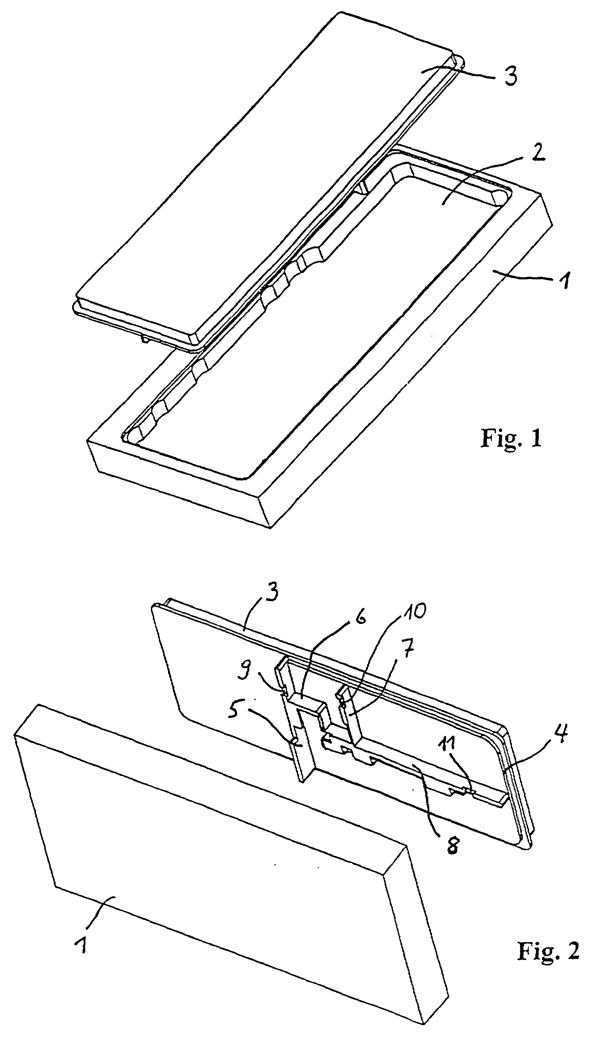

In der Figur 1 ist ein Abschirmgehäuse 1 perspektivisch dargestellt mit einer Ansicht in das Innere des Gehäuses. Das Abschirmgehäuse weist eine einzige große Kammer 2 auf, die z.B. frästechnisch aus einem Metallblock herausgearbeitet werden kann. Diese Kammer 2 dient zur Aufnahme von Mikrowellenschaltungen, die nach außen elektromagnetisch abgeschirmt werden sollen. Mit einem Deckel 3 wird das Gehäuse 1 verschlossen. Die Trennfuge zwischen den Gehäusewänden und dem Deckel muß so abgedichtet werden, daß dadurch keine elektromagnetische Energie abgestrahlt wird. In einem solchen Abschirmgehäuse befinden sich in der Regel mehrere Schaltungseinheiten, die ebenfalls gegeneinander elektromagnetisch abgeschirmt werden müssen. Deshalb werden im Innern des Gehäuses 1 mehrere Kammern zur Aufnahme einzelner gegeneinander elektromagnetisch zu entkoppelnder Schaltungseinheiten realisiert.

Wie die Kammern im Abschirmgehäuse 1 gebildet werden, zeigt die Figur 2, in der eine perspektivische Ansicht auf die Innenseite des Gehäusedeckels 3 dargestellt ist. Auf der Innenseite des Deckels 3 ist ein Substrat 4, das aus einem Polymer mit darin eingelagerten Metallpartikeln besteht, aufgebracht. Vorzugsweise ist das Substrat 4 eine mit Eisenpulver gefüllte Silikonmasse. An der dem Inneren des Gehäuses 1 zugewandten Seite ist das Substrat 4 mit mehreren Stegen 5, 6, 7, 8 versehen, die bei aufgesetztem Deckel 3 die Trennwände zwischen den einzelnen Kammern im Abschirmgehäuse bilden. Wie das Ausführungsbeispiel in Figur 2 andeutet, können die Stege 5, 6, 7, 8 eine beliebig komplizierte Struktur haben.

Das Substrat 4 mit seinen Stegen 5, 6, 7, 8 kann fertigungstechnisch auf einfache Weise mit einer Form auf die Innenseite des Deckels 3 aufgegossen werden. Die Stege 5, 6, 7, 8 liegen bei aufgesetztem Deckel 3 formschlüssig auf dem Boden der Kammer 2 auf und können zusätzlich mit Durchführungen 9, 10, 11 für Verbindungsleitungen zwischen den einzelnen Schaltungseinheiten versehen werden.

Die aus Polymer mit eingelagerten Metallpartikeln hergestellten Stege 5, 6, 7, 8 haben nicht nur die Funktion von Abschirmwänden, sondern bedämpfen gleichzeitig auch noch unerwünschte Resonanzfrequenzen in den Kammern.

## Patentansprüche

1. Abschirmgehäuse für Mikrowellenschaltungen, in dem sich mehrere gegeneinander abgeschirmte Kammern befinden, in denen Schaltungseinheiten angeordnet sind, die gegenseitig elektromagnetisch entkoppelt sein sollen, und bei dem auf der Innenseite eines das Gehäuse (1) verschließenden Deckels (3) ein Substrat (4) aus einem Polymer mit darin eingelagerten leitfähigen Partikeln aufgebracht ist, **dadurch gekennzeichnet, dass** die leitfähigen Partikel Metallpartikel sind und dass Stege (5, 6, 7, 8), welche bei aufgesetztem Deckel (3) die Trennwände zwischen den Kammern bilden, an dem Substrat (4) angeformt sind.

2. Abschirmgehäuse nach Anspruch 1, **dadurch gekennzeichnet, dass** das Polymer mit darin eingelagerten Metallpartikeln eine mit Eisenpulver gefüllte Silikonmasse ist.

## Claims

1. Shielding enclosure for microwave circuits having a plurality of mutually shielded chambers in which circuit units to be decoupled from each other are arranged and whereby on the inside of a cover (3) closing the housing (1) a substrate (4) made of a polymer containing conductive particles is applied, **characterised in that** the conductive particles are metal particles and that webs (5, 6, 7, 8) which, with the cover (3) applied, form the separating walls between the chambers are formed in the substrate (4).

2. Shielding enclosure according to Claim 1, **characterised in that** the polymer with enclosed metal particles is a silicone material filled with iron powder.

## Revendications

1. Boîtier de blindage pour des circuits à micro-ondes, dans lequel se trouvent plusieurs chambres rendues étanches entre elles, dame lesquelles sont disposées des unitée de circuits, qui doivent être découplées électromagnétiquement entre elles, tandis que sur la face interne d'un couvercle (3) obturant le boîtier est appliqué un substrat (4) en un polymère avec des particules conductrices incorporées, **caractérisé en ce que** les particules conductrices sont des particules métalliques et **en ce que** des barrettes (5,6,7,8) qui forment les parois de séparation entre les chambres lorsque le couvercle (3) est refermé, sont solidaires du substrat (4).

2. Boîtier selon la revendication 1, **caractérisé en ce que** le polymère avec les particules incorporées dans celui-ci est une matière au silicone remplie de poudre de fer.
